# EUROPÄISCHE PATENTSCHRIFT

(11) **EP 1 800 143 B1**
(45) Veröffentlichungstag und Bekanntmachung des Hinweises auf die Patenterteilung: **23.02.2011**
(21) Anmeldenummer: 05779255.8
(22) Anmeldetag: 24.08.2005
(51) Int. Cl.: G01R 31/36

(54) **VERFAHREN ZUR REKONSTRUKTION EINES ELEKTRISCHEN SIGNALS**
METHOD FOR RECONSTRUCTION OF AN ELECTRICAL SIGNAL
PROCEDE DE RECONSTRUCTION D'UN SIGNAL ELECTRIQUE

(30) Priorität: 05.10.2004 DE 102004048321; 28.07.2005 DE 102005035416
(43) Veröffentlichungstag der Anmeldung: 27.06.2007
(73) Patentinhaber: ROBERT BOSCH GMBH, 70442 Stuttgart (DE)
(72) Erfinder: Frey, Bernd, 73230 Kirchheim (DE); Iske, Burkhard, 71263 Weil Der Stadt (DE)
(86) Internationale Anmeldenummer: PCT/EP2005/054162
(87) Internationale Veröffentlichungsnummer: WO 2006/037694

(56) Entgegenhaltungen:
- EP-A- 1 055 934
- WO-A-01/51947
- FR-A- 2 835 923
- US-A- 3 676 770
- US-A- 4 390 841
- US-A- 4 849 700
- US-A- 5 281 919
- US-A- 5 592 094
- US-A- 5 698 983
- US-A- 5 703 486
- US-A- 6 002 238
- US-A- 6 044 331
- US-A- 6 115 675
- US-B1- 6 417 670
- PATENT ABSTRACTS OF JAPAN Bd. 007, Nr. 278 (P-242), 10. Dezember 1983 (1983-12-10) & JP 58 156871 A (NISSAN JIDOSHA KK), 17. September 1983 (1983-09-17)

## Beschreibung

Die Erfindung betrifft ein Verfahren zur Rekonstruktion eines analogen elektrischen Signals gemäß dem Oberbegriff des Patentanspruchs 1, sowie eine entsprechende Vorrichtung gemäß dem Oberbegriff des Patentanspruchs 7.

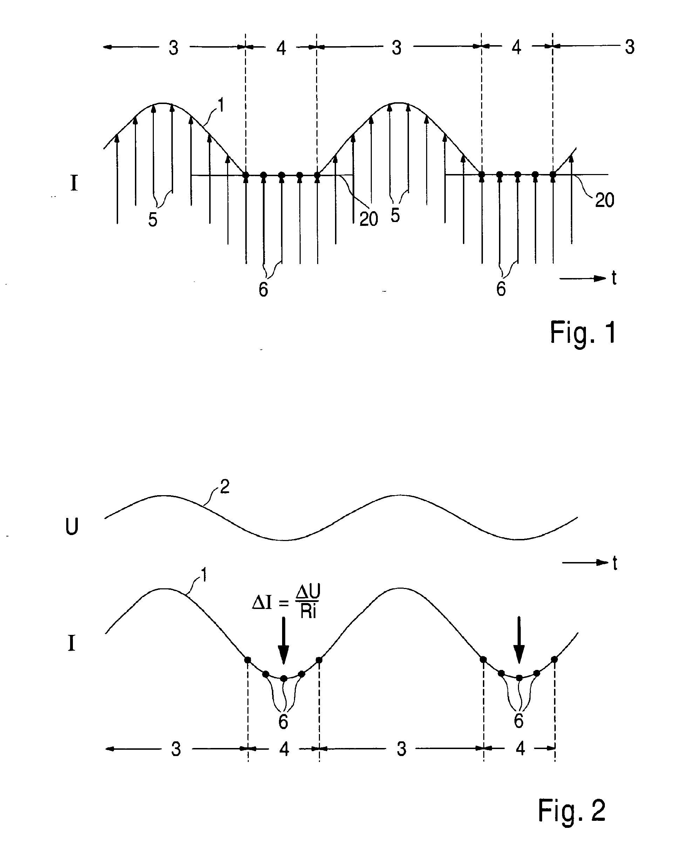

In der digitalen Messtechnik ist es bekannt, ein analoges Messsignal mittels eines A/D-Wandlers mit hoher Abtastrate abzutasten und danach digital weiter zu verarbeiten. Vor der Abtastung wird das Sensorsignal üblicherweise Tiefpass gefiltert, um das Abtasttheorem einzuhalten. Dadurch ist gewährleistet, dass keine Frequenzen im Sensorsignal auftreten, die größer sind als die halbe Abtastfrequenz. Bei manchen Messanordnungen ist es aus technischen Gründen jedoch nicht möglich, Tiefpassfilter mit einer ausreichend geringen Grenzfrequenz einzusetzen. In diesem Fall ist das Auftreten von Aliasing an einem nachgeschalteten digitalen Tiefpassfilter nicht zu verhindern. Dies wird am Beispiel von Fig. 1 näher erläutert:

Fig. 1 zeigt das Stromsignal I eines Stromsensors, der nach dem induktiven Messprinzip arbeitet. Dabei wird die Polarisation einer Sensorspule periodisch umgeschaltet. Während dieses Umschaltvorgangs können keine gültigen Strom-Messwerte aufgenommen werden. Der Bereich, in dem keine gültigen Messwerte aufgenommen werden können, ist hier mit dem Bezugszeichen 4, und der Bereich, in dem der Stromsensor gültige Messwerte liefert, mit dem Bezugszeichen 3 gekennzeichnet.

Um das Stromsignal I in den ungültigen Messbereichen 4 zu rekonstruieren, ist es bekannt, die fehlenden Messwerte z.B. über eine Geradengleichung zu approximieren. Dabei wird zwischen den letzten gültig gemessenen Stromwert und den nächsten gültig gemessenen Stromwert eine Gerade 20 gelegt und mehrere auf dieser Geraden 20 liegende Zwischenwerte 6 berechnet. In der Figur sind gültige Abtastwerte mit dem Bezugszeichen 5 und rekonstruierte Abtastwerte mit dem Bezugszeichen 6 bezeichnet. Das approximierte Signal 1 ist je nach Phasenlage der rekonstruierten Werte mit einem unterschiedlich großen Fehler behaftet. Durch eine nachgeordnete Tiefpassfilterung wird das Signal 1 ausgeblendet und lediglich der Fehler der Rekonstruktion bleibt erhalten. Da dieser Fehler nicht konstant ist, sondern mit der Phasenlage der rekonstruierten Werte schwankt, entsteht ein niederfrequentes Fehlersignal am Ausgang des Tiefpasses, welches als Aliasing betrachtet werden kann.

Aus der US-A-5,744,931 ist bereits eine Vorrichtung zur Ermittlung der verbleibenden Batteriekapazität bekannt. Hierzu wird eine Spannung ermittelt, die von der verbleibenden Kapazität der Batterie abhängt. Hierzu wird eine lineare Funktion I = aV + b aufgestellt. Diese Funktion wird mit Hilfe der Methode der kleinsten Quadrate ermittelt.

Es ist daher die Aufgabe der vorliegenden Erfindung, ein Verfahren sowie eine Vorrichtung zur Rekonstruktion eines abgetasteten analogen elektrischen Signals zu schaffen, bei dem das Auftreten von Aliasing wesentlich reduziert oder vollständig eliminiert werden kann.

Gelöst wird diese Aufgabe gemäß der Erfindung durch die im Patentanspruch 1 sowie im Patentanspruch 7 angegebenen Merkmale. Weitere Ausgestaltungen der Erfindung sind Gegenstand von Unteransprüchen.

Ein wesentlicher Gedanke der Erfindung besteht darin, in zeitlichen Abschnitten des analogen elektrischen Signals, in denen keine gültigen Abtastwerte erzeugt werden können, die fehlenden Abtastwerte des analogen elektrischen Signals aus Abtastwerten eines zweiten analogen elektrischen Signals zu berechnen, das mit dem ersten analogen elektrischen Signal gemäß einer vorgegebenen Funktion f in Zusammenhang steht, also das Signal auf Basis eines zweiten analogen elektrischen Signals zu rekonstruieren. Wenn der funktionale Zusammenhang zwischen den beiden Signalen bekannt ist, kann ein fehlender Abtastwert in einfacher Weise berechnet werden. Dabei gilt: S1 = f(S2), wobei S1 ein rekonstruierter "Abtast"-Wert des ersten und S2 ein Abtastwert des zweiten analogen elektrischen Signals ist.

Eine Messanordnung zur Rekonstruktion eines abgetasteten analogen elektrischen Signals, die nach dem vorstehend beschriebenen Verfahren arbeitet, umfasst erfindungsgemäß eine erste Signalquelle (z.B. einen Stromsensor), die ein erstes analoges elektrisches Signal liefert, und eine zweite Signalquelle (z.B. einen Spannungssensor), die ein zweites analoges elektrisches Signal liefert, wobei die beiden analogen elektrischen Signale gemäß einer vorgegebenen Funktion (I = f(U)) miteinander in Zusammenhang stehen. Die Messanordnung umfasst ferner zwei Abtasteinrichtungen zum Abtasten der beiden analogen elektrischen Signale. Ferner its eine Recheneinrichtung vorgesehen, der die Abtastwerte des zweiten analogen elektrischen Signals zugeführt werden und die die fehlenden Abtastwerte des ersten analogen elektrischen Signals unter Berücksichtigung des funktionellen Zusammenhangs aus den Abtastwerten des zweiten analogen elektrischen Signals berechnet.

Das erfindungsgemäße Verfahren zur Rekonstruktion eines analogen elektrischen Signals kann beispielsweise dazu eingesetzt werden, den Innenwiderstand (Ri) einer Batterie zu messen. In diesem Fall umfasst die Messanordnung einen Stromsensor, sowie einen Spannungssensor, aus deren Signalen der Innenwiderstand berechnet wird. Für den Innenwiderstand Ri gilt hierbei: Ri = deltaU/deltal. In zeitlichen Abschnitten, in denen keine gültigen Abtastwerte des Stromsignals erzeugt werden können, werden die fehlenden Abtastwerte vorzugsweise nach folgender Beziehung berechnet: deltaI = deltaU/Ri. Dabei bildet der Innenwiderstand Ri den funktionellen Zusammenhang. Das Stromsignal I wird also auf Basis von Abtastwerten des Spannungssignals und der Funktion f rekonstruiert. Der funktionelle Zusammenhang f (z.B. der Innenwiderstand Ri) wird vorzugsweise kontinuierlich neu berechnet.

Gemäß einer speziellen Ausführungsform der Erfindung berechnet die Recheneinrichtung die Abtastwerte des ersten analogen elektrischen Signals auch in zeitlichen Abschnitten, in denen das erste analoge elektrische Signal gültig ist und ermittelt eine Differenz zwischen rekonstruierten und gemessenen Abtastwerten (oder zwischen abgeleiteten Größen, wie z.B. die Differenz zwischen einem gemessenen und einem aus rekonstruierten Werten bestimmten Innenwiderstand Ri). Die Differenz wird vorzugsweise mit einem vorgegebenen Schwellenwert verglichen. Wenn die Differenz kleiner ist als der Schwellenwert, wird das erste analoge elektrische Signal in den ungültigen Abschnitten auf Basis des zweiten analogen elektrischen Signals rekonstruiert. Wenn die Differenz den Schwellenwert dagegen überschreitet, wird vorzugsweise auf ein anderes Interpolationsverfahren (z.B. lineare Interpolation) umgeschaltet und die fehlenden Abtastwerte mit diesem Verfahren bestimmt. Dadurch kann verhindert werden, dass eine Größe, die aus dem rekonstruierten Signal berechnet wird (wie z.B. der Innenwiderstand einer Batterie), auf Grundlage von ungültigen Werten berechnet wird. Diese Überwachung bleibt vorzugsweise ständig aktiv und entscheidet anhand der Differenz zwischen den berechneten und gemessenen Werten, ob in den ungültigen Abschnitten eine Rekonstruktion des ersten analogen elektrischen Signals auf Basis abhängiger Messgrößen durchgeführt werden darf oder nicht.

Die Erfindung wird nachstehend anhand der beigefügten Zeichnungen beispielhaft näher erläutert. Es zeigen: mit dem Bezugszeichen 6 bezeichnet. Das approximierte Signal 1 ist je nach Phasenlage der rekonstruierten Werte mit einem unterschiedlich großen Fehler behaftet. Durch eine nachgeordnete Tiefpassfilterung wird das Signal 1 ausgeblendet und lediglich der Fehler der Rekonstruktion bleibt erhalten. Da dieser Fehler nicht konstant ist, sondern mit der Phasenlage der rekonstruierten Werte schwankt, entsteht ein niederfrequentes Fehlersignal am Ausgang des Tiefpasses, welches als Aliasing betrachtet werden kann.

Es ist daher die Aufgabe der vorliegenden Erfindung, ein Verfahren sowie eine Vorrichtung zur Rekonstruktion eines abgetasteten elektrischen Signals zu schaffen, bei dem das Auftreten von Aliasing wesentlich reduziert oder vollständig eliminiert werden kann.

Gelöst wird diese Aufgabe gemäß der Erfindung durch die im Patentanspruch 1 sowie im Patentanspruch 6 angegebenen Merkmale. Weitere Ausgestaltungen der Erfindung sind Gegenstand von Unteransprüchen.

Ein wesentlicher Gedanke der Erfindung besteht darin, in zeitlichen Abschnitten des analogen Signals, in denen keine gültigen Abtastwerte erzeugt werden können, die fehlenden Abtastwerte des Signals aus Abtastwerten eines zweiten Signals zu berechnen, das mit dem ersten Signal gemäß einer vorgegebenen Funktion f in Zusammenhang steht, also das Signal auf Basis eines zweiten Signals zu rekonstruieren. Wenn der funktionale Zusammenhang zwischen den beiden Signalen bekannt ist, kann ein fehlender Abtastwert in einfacher Weise berechnet werden. Dabei gilt: S1 = f(S2), wobei S1 ein rekonstruierter "Abtast"-Wert des ersten und S2 ein Abtastwert des zweiten Signals ist.

Eine Messanordnung zur Rekonstruktion eines abgetasteten elektrischen Signals, die nach dem vorstehend beschriebenen Verfahren arbeitet, umfasst erfindungsgemäß eine erste Signalquelle (z.B. einen Stromsensor), die ein erstes analoges Signal liefert, und eine zweite Signalquelle (z.B. einen Spannungssensor), die ein zweites elektrisches Signal liefert, wobei die beiden Signale gemäß einer vorgegebenen Funktion (I = f(U)) miteinander in Zusammenhang stehen. Die Messanordnung umfasst ferner zwei Abtasteinrichtungen zum Abtasten der beiden Signale. Ferner ist eine Recheneinrichtung vorgesehen, der die Abtastwerte des zweiten Signals zugeführt werden und die die fehlenden Abtastwerte des ersten Signals unter Berücksichtigung des funktionellen Zusammenhangs aus den Abtastwerten des zweiten Signals berechnet.

Das erfindungsgemäße Verfahren zur Rekonstruktion eines abgetasteten Signals kann beispielsweise dazu eingesetzt werden, den Innenwiderstand (Ri) einer Batterie zu messen. In diesem Fall umfasst die Messanordnung einen Stromsensor, sowie einen Spannungssensor, aus deren Signalen der Innenwiderstand berechnet wird. Für den Innenwiderstand Ri gilt hierbei: Ri = deltaU/deltal. In zeitlichen Abschnitten, in denen keine gültigen Abtastwerte des Stromsignals erzeugt werden können, werden die fehlenden Abtastwerte vorzugsweise nach folgender Beziehung berechnet: deltaI = deltaU/Ri. Dabei bildet der Innenwiderstand Ri den funktionellen Zusammenhang. Das Stromsignal I wird also auf Basis von Abtastwerten des Spannungssignals und der Funktion f rekonstruiert. Der funktionelle Zusammenhang f (z.B. der Innenwiderstand Ri) wird vorzugsweise kontinuierlich neu berechnet.

Gemäß einer speziellen Ausführungsform der Erfindung berechnet die Recheneinrichtung die Abtastwerte des ersten Signals auch in zeitlichen Abschnitten, in denen das erste Signal gültig ist und ermittelt eine Differenz zwischen rekonstruierten und gemessenen Abtastwerten (oder zwischen abgeleiteten Größen, wie z.B. die Differenz zwischen einem gemessenen und einem aus rekonstruierten Werten bestimmten Innenwiderstand Ri). Die Differenz wird vorzugsweise mit einem vorgegebenen Schwellenwert verglichen. Wenn die Differenz kleiner ist als der Schwellenwert, wird das erste Signal in den ungültigen Abschnitten auf Basis des zweiten Signals rekonstruiert. Wenn die Differenz den Schwellenwert dagegen überschreitet, wird vorzugsweise auf ein anderes Interpolationsverfahren (z.B. lineare Interpolation) umgeschaltet und die fehlenden Abtastwerte mit diesem Verfahren bestimmt. Dadurch kann verhindert werden, dass eine Größe, die aus dem rekonstruierten Signal berechnet wird (wie z.B. der Innenwiderstand einer Batterie), auf Grundlage von ungültigen Werten berechnet wird. Diese Überwachung bleibt vorzugsweise ständig aktiv und entscheidet anhand der Differenz zwischen den berechneten und gemessenen Werten, ob in den ungültigen Abschnitten eine Rekonstruktion des ersten Signals auf Basis abhängiger Messgrößen durchgeführt werden darf oder nicht.

Die Erfindung wird nachstehend anhand der beigefügten Zeichnungen beispielhaft näher erläutert. Es zeigen:
Fig. 1 ein Stromsignal eines induktiven Stromsensors mit Abtastwerten;
Fig. 2 ein Spannungssignal und ein rekonstruiertes Stromsignal;
Fig. 3 eine Messanordnung zur Berechnung des Innenwiderstands einer Batterie;
Fig. 4 ein gemessenes und ein berechnetes Stromsignal; und
Fig. 5 eine Messanordnung zur Berechnung des Innenwiderstands einer Batterie gemäß einer speziellen Ausführungsform der Erfindung.

Bezüglich der Erläuterung von Fig. 1 wird auf die Beschreibungseinleitung verwiesen.

Fig. 2 zeigt den zeitlichen Verlauf einer Bordnetzspannung U und eines Batteriestroms I in einem Kfz-Bordnetz. Die Bordnetzspannung U und der Batteriestrom I zeigen aufgrund der vielen Schaltvorgänge im Kfz-Bordnetz eine gewisse Welligkeit, d.h. einen dem Gleichstrom- bzw. der Gleichspannung überlagerten Wechselanteil.

Das Spannungssignal 2 ist ein stetiges Signal, das Stromsignal 1 hat dagegen aufgrund des induktiven Messprinzips des Stromsensors 8 periodische Abschnitte 4, in denen keine gültigen Messwerte vorliegen.

Für die Berechnung des Innenwiderstands Ri einer Batterie werden die beiden Analogsignale 1,2 mit einer vorgegebenen Abtastfrequenz abgetastet und danach digital weiter verarbeitet. In den Abschnitten 4 können keine gültigen Abtastwerte 5 erzeugt werden. Zur Rekonstruktion des Stromsignals 1 werden die fehlenden Abtastwerte 6 daher aus Messwerten des Spannungssignals 2 berechnet und das Signal 1 in den Abschnitten 4 interpoliert.

Batteriestrom I und Netzspannung U sind keine unabhängigen Messgrößen, sondern stehen über den Innenwiderstand Ri der Batterie in Verhältnis zueinander. Dieser Zusammenhang ist darüber hinaus relativ stationär im Vergleich zur Abtastfrequenz. Die fehlenden Abtastwerte des Stromsignals 1 können daher aus dem Verhältnis der Spannungsänderung deltaU zum Innenwiderstand Ri der Batterie berechnet werden, wobei für die Stromänderung gilt: DeltaI = deltaU/Ri.

Die fehlenden Abtastwerte 6 werden vorzugsweise mit derselben Frequenz erzeugt wie die Abtastfrequenz.

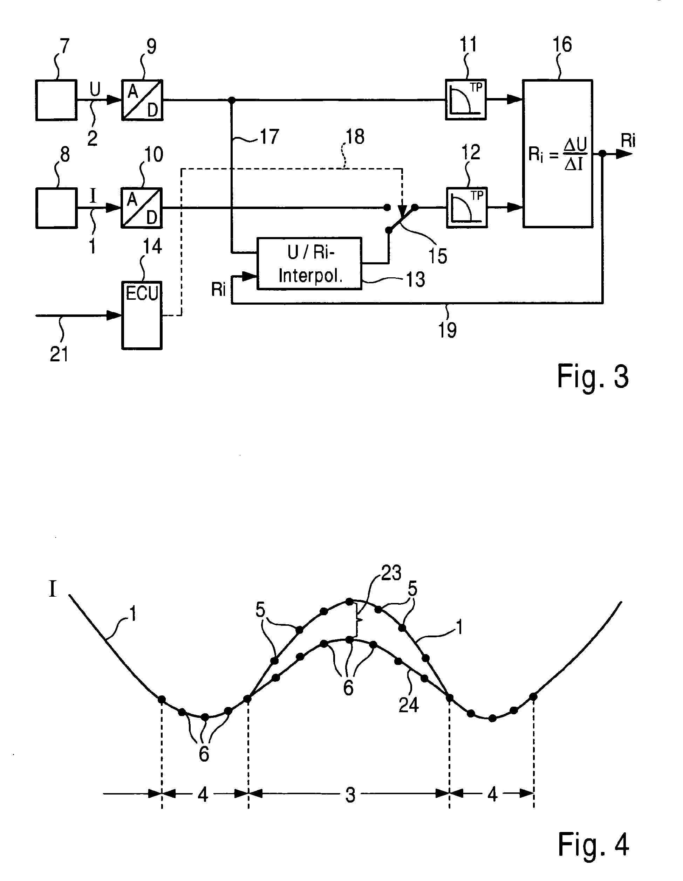

Fig. 3 zeigt eine Messanordnung zur Bestimmung des Innenwiderstands Ri einer Fahrzeugbatterie. Die Messanordnung umfasst einen Spannungssensor 7 zum Messen einer Netzspannung U, der ein analoges Spannungssignal 2 erzeugt, sowie einen Stromsensor zum Messen des Batteriestroms I, der ein analoges Stromsignal 1 erzeugt. Ein Tiefpassfilter (integriert im Block 7 bzw. 8) filtert die Signale 1,2, bevor sie den A/D-Wandlern 9,10 zugeführt werden. Durch die Tiefpass-Filterung wird sichergestellt, dass das Abtasttheorem möglichst gut eingehalten wird und die analogen Signale 1,2 möglichst keine Frequenzen enthalten, die größer als die halbe Abtastfrequenz der A/D-Wandler 9,10 ist.

Die digital gewandelten Signale 1,2 werden dann jeweils einem Tiefpass 11,12 zugeführt. Eine den Tiefpässen 11,12 nachgeordnete Prozessoreinheit 16, in der ein Rechenalgorithmus hinterlegt ist, berechnet dann den Innenwiderstand Ri der Batterie aus den gefilterten Signalen 1,2 gemäß der Beziehung:
Ri = delta U / delta I.

Wegen der vorstehend beschriebenen Abtastlücken 4 im abgetasteten Stromsignal 1 kann es am Ausgang des Tiefpasses 12 zum Auftreten von Aliasing und damit zu einer falschen Innenwiderstandsberechnung kommen. Um dies zu vermeiden, ist eine Recheneinheit 13 vorgesehen, die die Abtastwerte 6 in den ungültigen Signalabschnitten 4 aus dem Zusammenhang zwischen Strom I und Spannung U berechnet. Dabei gilt: delta I = delta U / Ri.

Die Recheneinrichtung 13 ist hierzu mit dem Ausgang der Prozessoreinheit 16 verbunden und erhält von dieser einen zuvor berechneten Wert für den Innenwiderstand Ri. Darüber hinaus ist die Recheneinheit 13 mit dem A/D-Wandler 9 verbunden und erhält von diesem einen aktuellen Abtastwert 5 des Spannungssignals 2. Der Ausgang der Recheneinheit 13 kann über einen Schalter 15 mit dem Tiefpass 12 in Verbindung gebracht werden.

In den Abtastlücken 4 wird der Schalter 15 von einer Logik 14 geschlossen (Steuerleitung 18) und somit der Ausgang der Recheneinheit 13 mit dem Tiefpass 12 verbunden. Die Einheit 16 erhält dann rekonstruierte Stromwerte 6 von der Recheneinheit 13. In den übrigen zeitlichen Abschnitten 3, in denen gültige Abtastwerte 5 erzeugt werden können, ist der Schalter 15 geöffnet. Dadurch kann der Innenwiderstand Ri fortlaufend richtig berechnet werden.

Die zeitlichen Abschnitte 4, in denen keine gültigen Messwerte vorliegen, sind aus einem Sensor-Umschaltsignal 21 bekannt, das der Logik 14 zugeführt wird.

Figur 4 zeigt das analoge Stromsignal 1 des Stromsensors 8 mit mehreren gemessenen Abtastwerten 5. Im mittleren Abschnitt 3 ist außerdem ein berechnetes Signal 24 mit mehreren rekonstruierten Werten 6 dargestellt, die mit Hilfe eines Spannungssignals berechnet wurden.

Im Unterschied zu Figur 2 werden hier die rekonstruierten Werte 6 nicht nur in den ungültigen Signalabschnitten 4, sondern auch in den gültigen Abschnitten 3 berechnet. Darüber hinaus wird eine Differenz 23 zwischen den gemessenen und rekonstruierten Werten 5 bzw. 6 (oder zwischen abgeleiteten Größen, wie z.B. die Differenz zwischen einem gemessenen und einem aus rekonstruierten Werten bestimmten Innenwiderstand Ri) berechnet, um die Genauigkeit der Ri-Berechnung zu überprüfen. Die Differenz ist bei einem quasi-stationären Verhalten der Signale U, I sehr klein, aber meist ungleich Null, da die Berechnung der rekonstruierten Werte auf Basis eines "veralteten" Innenwiderstandswerts Ri, also zeitlich verzögert erfolgt. Bei einem nicht-quasistationären Verhalten der Signale U, I (wie z.B. bei einem Wackelkontakt der Batterie) kann dagegen eine erhebliche Differenz 23 auftreten.

Solange die Differenz 23 kleiner ist als der Schwellenwert, wird das erste Signal auf Basis des zweiten Signals rekonstruiert. Wenn die Differenz 23 dagegen den Schwellenwert überschreitet, wird in den Signalabschnitten 4 auf ein anderes Interpolationsverfahren (z.B. lineare Interpolation) umgeschaltet und die fehlenden Abtastwerte mit diesem Verfahren bestimmt. Wenn die Differenz 23 den Schwellenwert wieder unterschreitet, kann mit der erfindungsgemäßen Rekonstruktion auf Grundlage des Spannungssignals U fortgefahren werden.

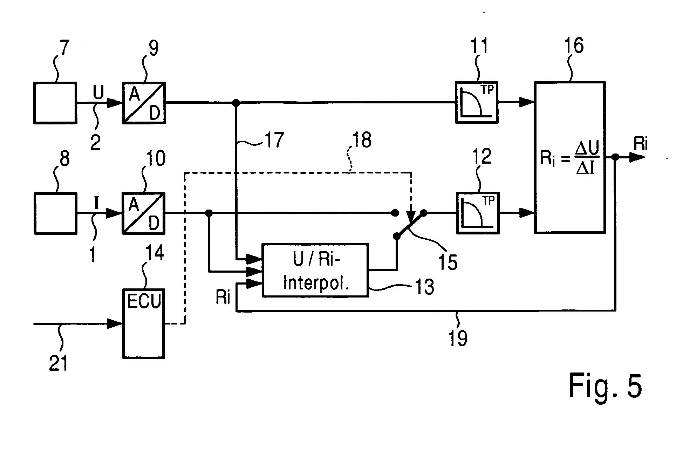

Figur 5 zeigt eine Messanordnung zur Bestimmung des Innenwiderstands Rᵢ einer Fahrzeugbatterie, bei der die Genauigkeit der Interpolation überwacht wird. Die Messanordnung ist im Wesentlichen identisch aufgebaut wie diejenige von Fig. 3 und umfasst wiederum einen Spannungssensor 7 und einen Stromsensor 8, deren Signale von zugeordneten Abtastgliedern 9 bzw. 10 abgetastet werden. Die abgetasteten Signale werden dann wiederum gefiltert (Tiefpassfilter 11 bzw. 12) und mittels des Algorithmus 16 der Innenwiderstand Rᵢ der Batterie berechnet.

Im Unterschied zu Figur 3 berechnet die Interpolationseinheit 13 die rekonstruierten Stromwerte 6 fortlaufend, also auch in den gültigen Abschnitten 3. Aus den gemessenen und rekonstruierten Stromwerten 5 bzw. 6 wird fortlaufend ein "gemessener" bzw. "rekonstruierter" Innenwiderstand Ri ermittelt. Die Einheit 13 berechnet außerdem eine Differenz zwischen dem gemessenen und rekonstruierten Innenwiderstand Ri und führt einen Schwellenwertvergleich durch, um die Genauigkeit der Ri-Berechnung zu überwachen. Wenn die Differenz kleiner ist als der Schwellenwert, wird das erste Signal in den ungültigen Abschnitten 4 auf Basis des zweiten Signals rekonstruiert und die entsprechenden Werte der Prozessoreinheit 16 zugeführt. Wenn die Differenz dagegen den Schwellenwert überschreitet, wird in den Signalabschnitten 4 auf ein anderes Interpolationsverfahren (z.B. lineare Interpolation) umgeschaltet und die fehlenden Abtastwerte mit diesem Verfahren bestimmt, da andernfalls der Fehler bei der Berechnung des Innenwiderstands Rᵢ zu groß werden könnte.

Die Überwachung der Ri-Berechnung ist vorzugsweise ständig aktiv und entscheidet anhand der Differenz zwischen dem gemessenen und dem berechneten Signal 1 bzw. 24, ob eine Rekonstruktion des Stromsignals 1 mittels des Spannungssignals 2 durchgeführt werden darf oder nicht.

### Bezugszeichenliste

- 1: Stromsignal
- 2: Spannungssignal
- 3: Gültiger Messbereich
- 4: Ungültiger Messbereich
- 5: Abtastwerte
- 6: Rekonstruierte Abtastwerte
- 7: Spannungssensor
- 8: Stromsensor
- 9: A/D-Wandler
- 10: A/D-Wandler
- 11: Digitaler Tiefpass
- 12: Digitaler Tiefpass
- 13: Recheneinrichtung
- 14: Logik
- 15: Schalter
- 16: Prozessoreinheit
- 17: Verbindungsleitung
- 18: Steuerleitung
- 19: Rückführung
- 20: Approximationsgerade
- 21: Umschaltsignal
- 23: Differenz
- 24: Berechnetes Signal
- I: Strom
- U: Spannung

## Patentansprüche

1. Verfahren zur Rekonstruktion eines ersten analogen elektrischen Signals (1), bei dem das erste analoge elektrische Signal (1) und ein zweites analoges elektrisches Signal (2), die gemäß einer vorgegebenen Funktion (f(U)) miteinander in Zusammenhang stehen, jeweils mit einer vorgegebenen Abtastrate abgetastet und gemessene Abtastwerte (5) des ersten und zweiten analogen elektrischen Signals (1, 2) erzeugt werden, wobei die gemessenen Abtastwerte (5) des ersten und zweiten analogen elektrischen Signals (1, 2) jeweils einem Tiefpass (11, 12) und anschließend einer Prozessoreinheit (16) zugeführt werden, aus denen die Prozessoreinheit (16) einen wert eines Innenwiderstands (Ri) ermittelt, **dadurch gekennzeichnet, dass** in zeitlichen Abschnitten (4), in denen aus dem ersten analogen elektrischen Signal (1) keine gültigen Abtastwerte (5) des ersten analogen elektrischen Signals (1) erzeugt werden können, rekonstruierte Abtastwerte (6) des ersten analogen elektrischen Signals (1) aus den gemessenen Abtastwerten (5) des zweiten analogen elektrischen Signals (2) unter Berücksichtigung der vorgegebenen Funktion (f(U)) durch eine Recheneinrichtung (13) berechnet werden unter Verwendung eines von der Prozessoreinheit (16) den berechneten Werts für den Innenwiderstand (Ri), wobei die rekonstruierten Abtastwerte (6) als gemessene Abtastwerte (5) des ersten analogen elektrischen Signals (1) in diesen zeitlichen Abschnitten (4) verwendet werden.

2. Verfahren nach Anspruch 1, **dadurch gekennzeichnet, dass** das erste analoge elektrische Signal (1) ein Stromsignal (I) und das zweite analoge elektrische Signal (2) ein Spannungssignal (U) ist.

3. Verfahren nach Anspruch 1 oder 2, **dadurch gekennzeichnet, dass** die rekonstruierten Abtastwerte (6) mit Hilfe der vorgegebenen Funktion deltaI = deltaU/Ri berechnet werden, wobei deltaI die Änderung des Stromsignals (I), deltaU die Änderung des Spannungssignals (U) und Ri ein Innenwiderstand einer Batterie ist.

4. Verfahren nach einem der vorhergehenden Ansprüche, **dadurch gekennzeichnet, dass** auch in zeitlichen Abschnitten (3), in denen das erste analoge elektrische Signal (1) gültig ist, rekonstruierte Abtastwerte (6) des ersten analogen elektrischen Signals (1) berechnet werden.

5. Verfahren nach Anspruch 4, **dadurch gekennzeichnet, dass** die Differenz zwischen den rekonstruierten (6) und gemessenen Abtastwerten (5) oder daraus abgeleiteten Werten ermittelt und mit einem Schwellenwert verglichen wird.

6. Verfahren nach Anspruch 5, **dadurch gekennzeichnet, dass** das erste analoge elektrische Signal (1) in den zeitlichen Abschnitten (4), in denen aus dem ersten analogen elektrischen Signal (1) keine gültigen Abtastwerte (5) erzeugt werden können auf Basis des zweiten analogen elektrischen Signals (2) rekonstruierte Abtastwerte (6) erzeugt werden wenn die Differenz (23) kleiner ist als der Schwellenwert, und den zeitlichen Abschnitten (4) in denen aus dem ersten analogen elektrischen Signal (1) keine gültigen Abtastwerte (5) erzeugt werden können auf ein Interpolationsverfahren umgeschaltet wird, wenn die Differenz (23) den Schwellenwert überschreitet.

7. Vorrichtung zur Rekonstruktion eines ersten analogen elektrischen Signals (1), umfassend eine erste (7) und eine zweite Signalquelle (8), die ein erstes bzw. zweites analoges elektrisches Signal (1, 2) erzeugen, wobei das erste und das zweite analoge elektrische Signal (1, 2) gemäß einer vorgegebenen Funktion (f(U)) miteinander in Zusammenhang stehen, sowie eine Abtasteinrichtung (9, 10) zum Abtasten des ersten und zweiten analogen elektrischen Signals (1, 2), so dass gemessene Abtastwerte (5) des ersten und zweiten analogen elektrischen Signals (1, 2) erzeugt werden, mit einer Prozessoreinheit (16), mit einem ersten und einem zweiten Tiefpass (11, 12), denen die gemessenen Abtastwerte (5) des ersten bzw. des zweiten analogen elektrischen Signals (1, 2) und anschließend der Prozessoreinheit (16) zugeführt sind, aus denen die Prozessoreinheit (16) einen wert eines Innenwiderstands (Ri) ermittelt, **dadurch gekennzeichnet, dass** eine Recheneinrichtung (13) vorgesehen ist, der die gemessenen Abtastwerte (5) des zweiten analogen elektrischen Signals (2) zugeführt sind, sodass in zeitlichen Abschnitten (4), in denen aus dem ersten analogen elektrischen Signal (1) keine gültigen Abtastwerte (5) des ersten analogen elektrischen Signals (1) erzeugt werden, die Recheneinrichtung (13) unter Berücksichtigung der vorgegebenen Funktion (f(U)) aus den gemessenen Abtaswerten (5) des zweiten analogen elektrischen Signals (2) rekonstruierte Abtastwerte (6) des ersten analogen elektrischen Signals (1) berechnet unter Verwendung des von der Prozessoreinheit (16) berechneten Werts für den Innenwiderstand (Ri), wobei die rekonstruierten Abtastwerte (6) des ersten analogen Signals als gemessene, Abtastwerte (5) des ersten analogen elektrischen Signals (1) in diesen zeitlichen Abschnitten (4) verwendet werden.

8. Vorrichtung nach Anspruch 7, **dadurch gekennzeichnet, dass** am Ausgang der Recheneinrichtung (13) ein Schalter (15) vorgesehen ist, mit dem die rekonstruierte Abtastwerte (6) in vorgegebenen Zeitabschnitten (4) der weiteren digitalen Verarbeitung zugeführt werden.

9. Vorrichtung nach Anspruch 7 oder 8, **dadurch gekennzeichnet, dass** der Tiefpass (12) zur Filterung der Abtastwerte des ersten analogen elektrische Signals vorgesehen ist, der mittels eines Schalters (15) wahlweise mit der Abtasteinrichtung (10) oder der Recheneinrichtung (13) verbindbar ist.

10. Vorrichtung nach einem der Ansprüche 7 bis 9, **dadurch gekennzeichnet, dass** die erste Signalquelle ein Stromsensor (7) und die zweite Signalquelle ein Spannungssensor (8) ist.

11. Vorrichtung nach Anspruch 7, **dadurch gekennzeichnet, dass** die Recheneinrichtung (13) auch in zeitlichen Abschnitten (3), in denen das erste analoge elektrische Signal (1) gültig ist, rekonstruierte Abtastwerte (6) des ersten analogen elektrischen Signals (1) berechnet.

12. Vorrichtung nach Anspruch 11, **dadurch gekennzeichnet, dass** die Differenz zwischen den rekonstruierten (6) und gemessenen Abtastwerten (5) ermittelt und mit einem Schwellenwert verglichen wird.

13. Vorrichtung nach Anspruch 12, **dadurch gekennzeichnet, dass** das erste analoge elektrische Signal (1) in den zeitlichen Abschnitten (4) in denen aus dem ersten analogen elektrischen Signal (1) keine gültigen Abtastwerte (5) erzeugt werden können auf Basis des zweiten analogen elektrischen Signals (2) erzeugt werden, wenn die Differenz (23) kleiner ist als der Schwellenwert, und den zeitlichen Abschnitten (4) in denen aus dem ersten analogen elektrischen Signal (1) keine gültigen Abtastwerte (5) erzeugt werden können auf ein Interpolationsverfahren umgeschaltet wird, wenn die Differenz (23) den Schwellenwert überschreitet.

## Claims

1. Method for reconstructing a first analogue electrical signal (1), in which the first analogue electrical signal (1) and a second analogue electrical signal (2) which are related to one another according to a predefined function (f(U)) are each sampled at a predefined sampling rate and measured samples (5) of the first and second analogue electrical signals (1, 2) are generated, the measured samples (5) of the first and second analogue electrical signals (1, 2) each being supplied to a low-pass filter (11, 12) and then to a processor unit (16) and being used by the processor unit (16) to determine a value of an internal resistance (Ri), **characterized in that**, in time segments (4) in which no valid samples (5) of the first analogue electrical signal (1) can be generated from the first analogue electrical signal (1), reconstructed samples (6) of the first analogue electrical signal (1) are calculated by a computation device (13) from the measured samples (5) of the second analogue electrical signal (2) taking into account the predefined function (f(U)) and using the value for the internal resistance (Ri), as calculated by the processor unit (16), the reconstructed samples (6) being used as measured samples (5) of the first analogue electrical signal (1) in these time segments (4).

2. Method according to Claim 1, **characterized in that** the first analogue electrical signal (1) is a current signal (I) and the second analogue electrical signal (2) is a voltage signal (U).

3. Method according to Claim 1 or 2, **characterized in that** the reconstructed samples (6) are calculated with the aid of the predefined function deltaI = deltaU/Ri, deltaI being the change in the current signal (I), deltaU being the change in the voltage signal (U) and Ri being an internal resistance of a battery.

4. Method according to one of the preceding claims, **characterized in that** reconstructed samples (6) of the first analogue electrical signal (1) are also calculated in time segments (3) in which the first analogue electrical signal (1) is valid.

5. Method according to Claim 4, **characterized in that** the difference between the reconstructed samples (6) and the measured samples (5) or values derived therefrom is determined and compared with a threshold value.

6. Method according to Claim 5, **characterized in that**, in the time segments (4) in which no valid samples (5) can be generated from the first analogue electrical signal (1), reconstructed samples (6) are generated on the basis of the second analogue electrical signal (2) if the difference (23) is less than the threshold value, and a changeover is made to an interpolation method in the time segments (4) in which no valid samples (5) can be generated from the first analogue electrical signal (1) if the difference (23) exceeds the threshold value.

7. Apparatus for reconstructing a first analogue electrical signal (1), comprising a first signal source (7) and a second signal source (8) which generate a first analogue electrical signal (1) and a second analogue electrical signal (2), respectively, the first and second analogue electrical signals (1, 2) being related to one another according to a predefined function (f(U)), as well as a sampling device (9, 10) for sampling the first and second analogue electrical signals (1, 2), with the result that measured samples (5) of the first and second analogue electrical signals (1, 2) are generated, having a processor unit (16), and having a first low-pass filter (11) and a second low-pass filter (12), to which the measured samples (5) of the first and second analogue electrical signals (1, 2) are supplied, said samples (5) then being supplied to the processor unit (16) and being used by the processor unit (16) to determine a value of an internal resistance (Ri), **characterized in that** provision is made of a computation device (13) which is supplied with the measured samples (5) of the second analogue electrical signal (2), with the result that, in time segments (4) in which no valid samples (5) of the first analogue electrical signal (1) are generated from the first analogue electrical signal (1), the computation device (13) calculates reconstructed samples (6) of the first analogue electrical signal (1) from the measured samples (5) of the second analogue electrical signal (2) taking into account the predefined function (f(U)) and using the value for the internal resistance (Ri), as calculated by the processor unit (16), the reconstructed samples (6) of the first analogue signal being used as measured samples (5) of the first analogue electrical signal (1) in these time segments (4).

8. Apparatus according to Claim 7, **characterized in that** a switch (15) is provided at the output of the computation device (13) and is used to supply the reconstructed samples (6) to further digital processing in predefined time segments (4).

9. Apparatus according to Claim 7 or 8, **characterized in that** the low-pass filter (12) is provided for filtering the samples of the first analogue electrical signal and can be connected either to the sampling device (10) or to the computation device (13) by means of a switch (15).

10. Apparatus according to one of Claims 7 to 9, **characterized in that** the first signal source is a current sensor (7) and the second signal source is a voltage sensor (8).

11. Apparatus according to Claim 7, **characterized in that** the computation device (13) also calculates reconstructed samples (6) of the first analogue electrical signal (1) in time segments (3) in which the first analogue electrical signal (1) is valid.

12. Apparatus according to Claim 11, **characterized in that** the difference between the reconstructed samples (6) and the measured samples (5) is determined and compared with a threshold value.

13. Apparatus according to Claim 12, **characterized in that**, in the time segments (4) in which no valid samples (5) can be generated from the first analogue electrical signal (1), reconstructed samples (6) are generated on the basis of the second analogue electrical signal (2) if the difference (23) is less than the threshold value, and a changeover is made to an interpolation method in the time segments (4) in which no valid samples (5) can be generated from the first analogue electrical signal (1) if the difference (23) exceeds the threshold value.

## Revendications

1. Procédé de reconstruction d'un premier signal électrique analogique (1), dans lequel
le premier signal électrique analogique (1) et un deuxième signal électrique analogique (2) qui présentent une relation mutuelle décrite par une fonction (f(U)) prédéterminée sont échantillonnés à un taux d'échantillonnage prédéterminé,
des valeurs mesurées d'échantillonnage (5) du premier et du deuxième signal électrique analogique (1, 2) sont formées,
les valeurs mesurées d'échantillonnage (5) du premier et du deuxième signal électrique analogique (1, 2) sont amenées chacune à un filtrage passe-bas (11, 12) et ensuite à une unité de processeur (16) et
l'unité de processeur (16) détermine à partir d'elles la valeur d'une résistance interne (Ri), **caractérisé en ce que**
au cours de segments temporels (4) pendant lesquels aucune valeur valide d'échantillonnage (5) du premier signal électrique analogique (1) n'a pu être formée à partir du premier signal électrique analogique (1), des valeurs reconstruites d'échantillonnage (6) du premier signal électrique analogique (1) sont calculées par une unité de calcul (13) à partir des valeurs mesurées d'échantillonnage (5) du deuxième signal électrique analogique (2) en tenant compte de la fonction prédéterminée (f(U)) et en recourant à la valeur de la résistance interne (Ri) calculée par l'unité de processeur (16), les valeurs reconstruites d'échantillonnage (6) étant utilisées comme valeurs mesurées d'échantillonnage (5) du premier signal électrique analogique (1) dans ces segments temporels (4).

2. Procédé selon la revendication 1, **caractérisé en ce que** le premier signal électrique analogique (1) est un signal de courant (I) et le deuxième signal électrique analogique (2) un signal de tension (U).

3. Procédé selon la revendication 1 ou 2, **caractérisé en ce que** les valeurs reconstruites d'échantillonnage (6) sont calculées à l'aide de la fonction prédéterminée deltaI = deltaU/Ri, deltaI représentant la variation du signal de courant (I), deltaU la modification du signal de tension (U) et Ri la résistance interne d'une batterie.

4. Procédé selon l'une des revendications précédentes, **caractérisé en ce que** des valeurs reconstruites d'échantillonnage (6) du premier signal électrique analogique (1) sont également calculées au cours des segments temporels (3) dans lesquels le premier signal électrique analogique (1) est valide.

5. Procédé selon la revendication 4, **caractérisé en ce que** la différence entre les valeurs reconstruites d'échantillonnage (6) et les valeurs mesurées d'échantillonnage (5) ou les valeurs qui en sont déduites est déterminée et comparée à une valeur de seuil.

6. Procédé selon la revendication 5, **caractérisé en ce que** si la différence (23) est inférieure à la valeur de seuil au cours des segments temporels (4) dans lesquels aucune valeur valide d'échantillonnage (5) n'a pu être formée à partir du premier signal électrique analogique (1), des valeurs reconstruites d'échantillonnage (6) sont formées sur base du deuxième signal électrique analogique (2), et **en ce que** si la différence (23) dépasse la valeur de seuil au cours des segments temporels (4) dans lesquels aucune valeur valide d'échantillonnage (5) n'a pu être formée à partir du premier signal électrique analogique (1), on commute sur un procédé d'interpolation.

7. Dispositif de reconstruction d'un premier signal électrique analogique (1) comportant
une première source (7) de signaux et une deuxième source (8) de signaux qui forment respectivement un premier et un deuxième signal électrique analogique (1, 2),
le premier et le deuxième signal électrique analogique (1, 2) présentant une relation mutuelle décrite par une fonction (f(U)) prédéterminée,
un dispositif d'échantillonnage (9, 10) qui échantillonne le premier et le deuxième signal électrique analogique (1, 2), de sorte que des valeurs mesurées d'échantillonnage (5) du premier et du deuxième signal électrique analogique (1, 2) sont formées, et
une unité de processeur (16), un premier et un deuxième filtre passe-bas (11, 12) auxquels les valeurs mesurées d'échantillonnage (5) du premier et du deuxième signal électrique analogique (1, 2) sont amenées avant d'être amenées à l'unité de processeur (16),
l'unité de processeur (16) déterminant à partir d'elles une résistance interne (Ri),
**caractérisé en ce que**
un dispositif de calcul (13) auquel sont amenées les valeurs mesurées d'échantillonnage (5) du deuxième signal électrique analogique (2), de telle sorte qu'au cours de segments temporels (4) au cours desquels aucune valeur valide d'échantillonnage (5) du premier signal électrique analogique (1) n'a été formée à partir du premier signal électrique analogique (1), le dispositif de calcul (13) calcule des valeurs reconstruites d'échantillonnage (6) du premier signal électrique analogique (1) à partir des valeurs mesurées d'échantillonnage (5) du deuxième signal électrique analogique (2) en tenant compte de la fonction prédéterminée (f(U)) et en utilisant la valeur, calculée par l'unité de processeur (16), de la résistance interne (Ri) et
**en ce que** les valeurs reconstruites d'échantillonnage (6) du premier signal analogique sont utilisées comme valeurs mesurées d'échantillonnage (5) du premier signal électrique analogique (1) au cours de ces segments temporels (4).

8. Dispositif selon la revendication 7, **caractérisé en ce qu'**un commutateur (15) par lequel les valeurs reconstruites d'échantillonnage (6) sont amenées au cours de segments temporels prédéterminés (4) au traitement numérique supplémentaire est prévu à la sortie du dispositif de calcul (13).

9. Dispositif selon la revendication 7 ou 8, **caractérisé en ce que** le filtre passe-bas (12) est prévu pour filtrer des valeurs d'échantillonnage du premier signal électrique analogique et peut être relié sélectivement au moyen d'un commutateur (15) au dispositif d'échantillonnage (10) ou au dispositif de calcul (13).

10. Dispositif selon l'une des revendications 7 à 9, **caractérisé en ce que** la première source de signaux est un détecteur de courant (7) et la deuxième source de signaux un détecteur de tension (8).

11. Dispositif selon la revendication 7, **caractérisé en ce que** le dispositif de calcul (13) calcule également des valeurs reconstruites d'échantillonnage (6) du premier signal électrique analogique (1) au cours des segments temporels (3) pendant lesquels le premier signal électrique analogique (1) est valide.

12. Dispositif selon la revendication 11, **caractérisé en ce que** la différence entre les valeurs reconstruites d'échantillonnage (6) et les valeurs mesurées d'échantillonnage (5) est déterminée et comparée à une valeur de seuil.

13. Dispositif selon la revendication 12, **caractérisé en ce que** si la différence (23) est inférieure à la valeur de seuil au cours des segments temporels (4) pendant lesquels aucune valeur valide d'échantillonnage (5) n'a pu être formée à partir du premier signal électrique analogique (1), des valeurs reconstruites d'échantillonnage (6) sont formées sur base du deuxième signal électrique analogique (2), et **en ce que** si la différence (23) dépasse la valeur de seuil au cours des segments temporels (4) pendant desquels aucune valeur valide d'échantillonnage (5) n'a pu être formée à partir du premier signal électrique analogique (1), on commute sur un procédé d'interpolation.
